Europäisches Patentamt

European Patent Office

Office européen des brevets

(11) Veröffentlichungsnummer: **0 054 306**

**A1**

# EUROPÄISCHE PATENTANMELDUNG

(21) Anmeldenummer: **81110493.4**

(22) Anmeldetag: **16.12.81**

(51) Int. Cl.³: **H 03 K 17/96**
**H 05 B 3/74**

(30) Priorität: **17.12.80 DE 8033570 U**

(43) Veröffentlichungstag der Anmeldung:
**23.06.82 Patentblatt 82/25**

(84) Benannte Vertragsstaaten:
**AT CH DE FR GB LI NL SE**

(71) Anmelder: **Bosch-Siemens Hausgeräte GmbH Stuttgart Patent- und Vertragswesen Hochstrasse 17 D-8000 München 80(DE)**

(72) Erfinder: **Brandl, Georg Mahd 3 D-8221 Pailing(DE)**

(72) Erfinder: **Gabor, Nagy, Dr. Hirschgartenstrasse 1 D-8201 Rosenheim-Aising(DE)**

(54) Kapazitiver Berührungsschalter für elektrische Hausgeräte.

(57) Ein kapazitiver Berührungsschalter vorzugsweise für Kochmulden aus Glas und Glaskeramik weist auf beiden Seiten eines aus dielektrischem, plattenartigem Materials bestehenden Schaltertableau Kondensatorflächen auf.

Auf der der Bedienseite abgewandten Seite des Schaltertableaus sind zwei an die Auswerteschaltung zu kontaktierenden Kondensatorflächen aufgebracht; auf der Bedienseite ist eine weitere Kondensatorfläche als Koppelelement angeordnet, das durch Annäherung eines Bedienorgans eine kapazitive Verstimmung verursacht.

FIG.1

EP 0 054 306 A1

BOSCH-SIEMENS HAUSGERÄTE GMBH
Stuttgart

8 München, den 08.12.1981
Hochstraße 17

0054306

TZP 80/653 E

## Kapazitiver Berührungsschalter für elektrische Hausgeräte

Die vorliegende Erfindung bezieht sich auf einen kapazitiven Berührungsschalter für elektrische Hausgeräte, vorzugsweise für Kochmulden aus Glas oder Keramik, mit auf beiden Seiten eines aus dielektrischem, plattenartigem Material bestehenden Schaltertableau aufgebrachten Kondensatorflächen.

Es sind kapazitive Berührungsschalter bekannt, bei denen auf beiden gegenüberliegenden Flächen einer, ein Schalttableau darstellenden Platte aus dielektrischem Material Kondensatorflächen oder allgemein Elektroden aufgebracht z.B. aufgedampft sind. Durch mittelbare oder unmittelbare Berührung der äußeren Kondensatorflächen durch den Finger der Bedienungsperson wird die kapazitive Anordnung verstimmt und es erfolgt die Abgabe eines Schaltsignals, das z.B. durch eine nachgeschaltete Relaisschaltung zur Durchführung eines Schaltvorganges auswertbar ist. Bei derartigen Anordnungen besteht eine gewisse Problematik darin, daß beide beidseitig des dielektrischen Materials angeordneten Kondensatorflächen an die angeschlossene Auswerteeinheit ankontaktiert werden müssen. Dies bedeutet, daß eine dieser Kondensatorflächen, nämlich die, die auf der Bedienseite angeordnet ist, durch das dielektrische Material hindurch kontaktiert werden muß.

Es ist auch bekannt, beide Kondensatorflächen auf derselben Seite, bevorzugterweise auf der der Bedienseite des dielektrischen Materials entgegengesetzten Seite anzuordnen.

Damit sind die Kontaktierprobleme wesentlich vereinfacht, es ergibt sich aber in diesem Fall die Schwierigkeit, daß die Verstimmung der Kondensatorwirkung getrennt durch das Dielektrikum lediglich in schmalen Randbereichen erfolgen kann. Damit ist die Funktionstüchtigkeit derartiger Anordnungen wesentlich beeinträchtigt.

Aufbauend auf diesem Stand der Technik ist es Aufgabe der vorliegenden Erfindung, einen kapazitiven Berührungsschalter bereitzustellen, welcher zum einen herstellungstechnisch einfach ist und zum anderen eine hohe Funktionssicherheit bietet. Insbesondere soll die Möglichkeit geschaffen sein, den Beeinflussungsbereich, d.h. die aktive Fläche des kapazitiven Berührungsschalters so auszugestalten, daß Annäherungen und Berührungen an beliebigen Stellen dieses Bereiches und mit beliebiger Ausdehnung in diesem Bereich im wesentlichen zu gleichen Schaltkriterien führen.

Ein kapazitiver Berührungsschalter, der diesen Anforderungen gerecht wird, ist erfindungsgemäß dadurch gekennzeichnet, daß auf der der Bedienseite für die Eingabe eines Schaltbefehls gegenüberliegenden Seite des dielektrischen, plattenartig ausgebildeten Materials je Eingabestelle zwei Kondensatorflächen aufgebracht sind, von denen eine erste Kondensatorfläche an einem Frequenzgenerator und eine zweite Kondensatorfläche an einer Auswerteschaltung angeschlossen sind, und daß auf der Bedienseite eine zumindest den Bereich dieser beiden Kondensatorflächen überdeckende weitere Kondensatorfläche angeordnet ist.

Der Vorteil einer nach diesen Merkmalen ausgestalteten Anordnung besteht darin, daß die mit der Schaltungsanordnung zu kontaktierenden Kondensatorflächen des kapazitiven Berührungsschalters, da sie auf der gleichen und der Schaltungsanordnung benachbarten Seite des dielektrischen Materials angeordnet sind, einfach kontaktierbar sind und daß bei Annäherung bzw. Berührung der auf der Bedienseite des dielektrischen Materials angeordneten Kondensatorfläche in weiten Betätigungsbereichen jeweils gleiche Kondensatorverstimmungen, die durch die Auswerteschaltung zu verarbeiten sind, erfolgen.

Nach einer bevorzugten Ausgestaltung ist der erfindungsgemäße kapazitive Berührungsschalter dadurch gekennzeichnet, daß die auf der Bedienseite des dielektrischen, plattenartigen Materials angeordnete Kontaktfläche sich über den Bereich der auf der anderen Seite angeordneten Kondensatorflächen hinaus erstreckt. Damit wird der aktive Bereich für die Kondensatorwirkung durch die Fläche der beiden auf der der Bedienseite gegenüberliegenden Seite des dielektrischen, plattenartigen Materials angeordneten Kondensatorflächen festgelegt, während die aktive Fläche des Berührungsschalters über diesen Bereich fast beliebig erweiterbar ist und zwar auf die Fläche der auf der Bedienseite angeordneten Kondensatorfläche. Unabhängig davon, an welcher Stelle dieses Bereiches eine Annäherung oder eine Berührung erfolgt, ist die Verstimmung der Kondensatorwirkung annähernd gleich.

Diese bevorzugte Ausgestaltung läßt sich dahingehend ausnutzen, daß die auf der Bedienseite des dielektrischen Materials angeordnete Kondensatorfläche einer zum Eingabeschutz ausgebildeten Eingabestelle in die Randbereiche der übrigen Eingabestellenflächen herangeführt ist. Damit eignet sich der in erfindungsgemäßer Weise ausgestaltete kapazitive Berührungsschalter besonders auch für Schalteranordnungen mit Schutzfunktionen gegen Fehlbedienungen, welche beispielsweise hervorgerufen würden, wenn über die Schaltstellen hinweggewischt wird.

Bevorzugterweise ist die erste Kondensatorfläche an einen Frequenzgenerator angeschlossen, dessen Schwenkfrequenz zwischen 20 und 200 kHz liegt. Im Rahmen integrierter Schaltkreistechnik ist der Frequenzgenerator in einfacher Weise gebildet durch einen aus astabilen Kippstufen aufgebauten Multivibrator.

In einem Schalttableau sind in vielen Fällen eine Mehrzahl von Eingabeschaltelementen angeordnet. Nach einer bevorzugten Weiterbildung ist eine Anordnung einer Mehrzahl von kapazitiven Berührungsschaltern, welche über eine Mikroprozessorsteuerung auswertbar sind, dadurch gekennzeichnet, daß über eine aus Und-Verknüpfungsgliedern aufgebaute Torschaltung in Abhängigkeit der von der Mikroprozessorsteuerung gelieferten Auswahlsignale der Frequenzgenerator zyklisch den ersten Kondensatorflächen der Eingabestellen zuschaltbar ist. Damit können die einzelnen kapazitiven Berührungsschalter in einer Art ausgewertet werden, daß sie durch eine nachgeschaltete Mikroprozessorsteuerung funktionsgerecht ausgewertet werden können.

Nach einer anderen bevorzugten Weiterbildung ist eine Anordnung einer Mehrzahl von kapazitiven Berührungsschaltern dadurch gekennzeichnet, eine Mehrzahl von zweiten Kondensatorflächen der Eingabestellen gemeinsam einer Auswerteeinrichtung der Auswerteschaltung zugeführt ist. Bereits auf dem dielektrischen, plattenartigen Material können diese zweiten Kondensatorflächen miteinander in Verbindung stehen und somit eine flächige Einheit bilden.

Es ist im Rahmen der Erfindung zweckmäßig, zwischen der zweiten Kondensatorfläche und der Auswerteschaltung einen Schaltverstärker zwischenzuschalten, um das durch den kapazitiven Berührungsschalter abgegebene Schaltsignal für die nachfolgende Auswerteeinrichtung aufzubereiten.

Bei Verwendung derartiger kapazitiver Berührungsschalter bei Haushaltsgeräten, insbesondere bei Kochmulden, besteht der Nachteil, daß die äußere, metallische Kondensatorfläche wenig kratzfest ist und daher etwa beim säubern der Kochmuldenoberfläche durch mechanische oder chemische Einwirkungen beschädigt wird. Außerdem stört die metallische Kondensatoroberfläche auf der Bedienseite den optischen Gesamteindruck der Bedienfläche.

Aus diesem Grunde ist es nach einer besonderen bevorzugten Ausführungsform zweckmäßig, den kapazitiven Berührungsschalter dahingehend auszugestalten, daß die Kondensatorfläche auf der Bedienseite durch eine auf das Schalttableau unlösbar aufgebrachte dielektrische Schicht überzogen ist.

Durch das Vorhandensein einer gegenüber äußeren mechanischen und chemischen Einflüssen resistenten Schicht, z.B. einer Glasschicht, kann eine Beschädigung oder Verunstaltung der äußeren Kondensatorfläche nicht mehr erfolgen. Vielmehr liegt diese Kondensatorfläche geschützt hinter der vorgenannten resistenten, dielektrischen Schicht, was insbesondere dann von großem Vorteil ist, wenn der kapazitive Berührungsschalter unmittelbar auf der Kochmulde, z.B. einer Glaskeramik-Kochmulde, angeordnet ist. Ferner ergibt sich durch diese Maßnahme der Vorteil, daß das äußere Erscheinungsbild der Schaltfläche beliebig an das Erscheinungsbild der Schalttableau-Oberfläche angepaßt, z.B. mit entsprechenden Mustern versehen werden kann. Die leitende, äußere Kondensatorfläche ist hierbei nicht mehr sichtbar. Ferner besteht die Möglichkeit, für die Kondensatorflächen ein relativ billiges, leicht zu bearbeitendes Material zu verwenden, im Gegensatz zu bekannten, derartigen Berührungsschaltern mit äußerer Kondensatorfläche, z.B. aus Edelmetall. Vorzugsweise ist die äußere Kondensatorfläche durch eine kratzfeste Dekorschicht, vorzugsweise aus Glas, Keramik oder Glaskeramik überzogen. Gemäß einer weiteren vorteilhaften Ausgestaltung der Erfindung bestehen die Kondensatorflächen auf der der Bedienseite entgegengesetzten Rückseite des Schalttableaus aus einem lötbaren Material, vorzugsweise aus einer Silberleitpaste, an die elektrische Leitungen angelötet sind. Auf diese Weise erhält man in bezug auf die Anordnung des Berührungsschalters bzw. des Schalttableaus relativ zu einer nachgeschalteten elektrischen Steuerung völlige Freizügigkeit, da die elektrische Verbindung zwischen Berührungsschalter und Steuerung mittels flexiblen elektrischen Leitern erfolgen kann. Im Gegensatz hierzu erfolgt bei der bekannten Anordnung einer elektrischen Verbindung zwischen Berührungsschalter und einer Auswerteschaltung, z.B. einer Relaisschaltung, mittels Kontaktfedern, was eine unmittelbare geometrische Zuordnung dieser beiden Funktionsgruppen notwendig macht.

Ein nach den Merkmalen der Erfindung ausgestaltetes Ausführungsbeispiel ist anhand der Zeichnung im folgenden näher beschrieben. Es zeigen:

Fig. 1 einen kapazitiven Berührungsschalter in einer Seitenansicht,

Fig. 2 eine Anordnung einer Mehrzahl von Kondensatorflächen auf der der Bedienseite gegenüberliegenden Seite des dielektrischen, plattenartigen Materials,

Fig. 3 die Kondensatorflächen auf der Bedienseite des dielektrischen, plattenartigen Materials und

Fig. 4 eine Schaltungsanordnung im Umfeld derartiger kapazitiver Berührungsschalter.

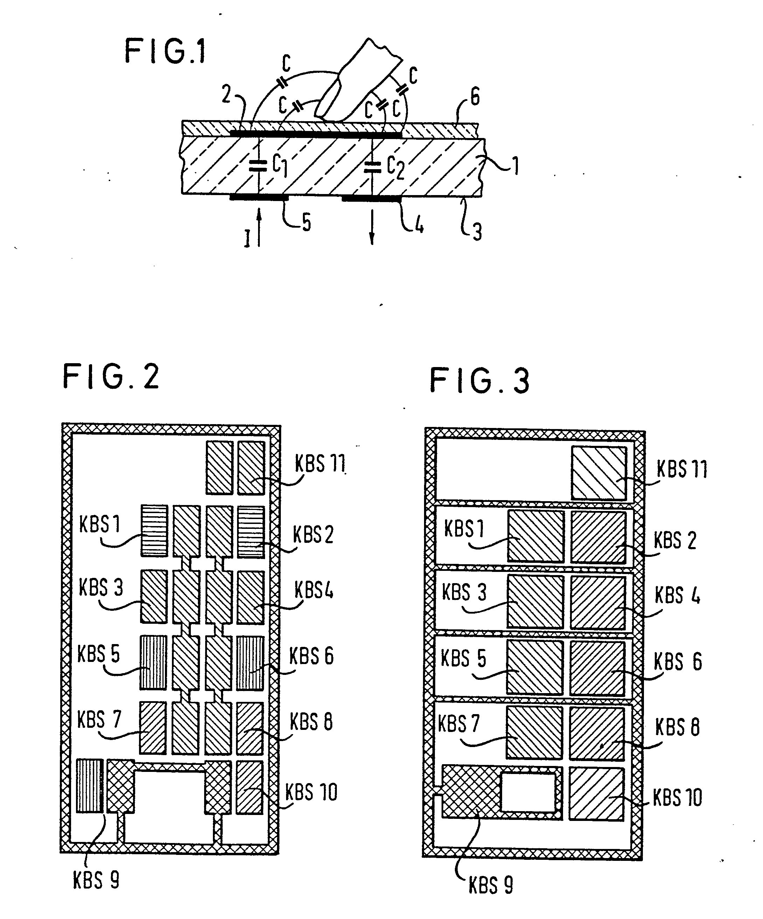

Gemäß Fig. 1 ist auf der oberen bzw. äußeren Oberfläche einer Glasplatte 1 eine relativ große Kondensatorfläche 2 unlösbar aufgebracht. Als Material für die sehr dünne Kondensatorfläche 2 dient eine lötbare Silberleitpaste, die durch ein Siebdruckverfahren auf die Glasoberfläche aufgebracht ist. Auf der der Bedienseite entgegengesetzten Rückseite 3 der Glasplatte 1 sind nach demselben Verfahren und aus demselben Material bestehende Kondensatorflächen 4 und 5 aufgebracht. Auch diese Kondensatorflächen 4, 5 sind lötbar, so daß nicht dargestellte elektrische Leitungen daran angelötet werden können, welche Leitungen z.B. zu einer elektrisch nachgeschalteten Auswerte-oder Relaisschaltung führen. Zum Schutz der äußeren Kondensatorfläche 2 gegenüber mechanischen und chemischen Einflüssen ist
auf die Bedienseite des Schalttableaus 1 eine dielektrische
Schicht 6, z.B. eine kratzfeste Glasschicht, aufgebracht. Diese
in Wirklichkeit sehr dünne Schicht 6 überzieht die gesamte
Kondensatorfläche 2 und setzt sich auch darüber hinaus fort.
Das äußere Erscheinungsbild dieser äußeren Schicht 6 ist beliebig variierbar. Sie kann, in Anpassung an das Erscheinungsbild der übrigen Schalttableaus-Oberfläche, z.B. entsprechend
eingefärbt oder mit einem Dekormuster ausgestattet sein. Insbesondere ist sie undurchsichtig, so daß die mechanische Kondensatorfläche 2 nicht mehr sichtbar ist. An Material für die
Schicht 6 kann aber auch Keramik oder Glaskeramik verwendet
werden. Die eingezeichneten Schaltsymbole sollen lediglich die
Funktionsweise des kapazitiven Berührungsschalters verdeutlichen
Wie zu ersehen ist, bilden die Kondensatorflächen 2 einerseits
und 4 und 5 andererseits zusammen mit der Glasplatte 1 als
Dielektrikum jeweils zwei in Reihe geschaltete Kondensatoren
C1 und C2. Ist beispielsweise an der Kondensatorfläche 5 eine
möglichst hochfrequent arbeitende Stromquelle angeschlossen,
so fließt über die Kapazitäten C1 und C2 jeweils ein Strom I,
dessen Größe durch eine der Kondensatorfläche 4 nachgeschaltete Auswerteschaltung auswertbar ist. Durch die Berührung der
äußeren Schicht 6 im Bereich der äußeren Kondensatorfläche 2
wird eine weitere Kapazität C gebildet, welche die Wirkung
der Kapazitäten C1 oder C2 wesentlich verändert. Der größte
Anteil des hochfrequenten Stromes I fließt nunmehr über die
Kapazität C, so daß an der Kondensatorfläche 4 nunmehr nur ein
sehr geringer Strompegel ansteht. Dieses Kriterium wird als
Schaltbefehl ausgewertet.

Die Figuren 2 und 3 zeigen Kondensatorflächen einer Mehrzahl
von kapazitiven Berührungsschaltern, wobei in Fig. 2 einfach
schraffiert die der Kondensatorfläche 4 nach Fig. 1 entspreche
den Kondensatorflächen und kreuzweise schraffiert die der Kon-

densatorfläche 5 nach Fig. 1 entsprechenden Kondensatorflächen und in Fig. 3 die der Kondensatorfläche 2 nach Fig. 1 entsprechenden Kondensatorflächen dargestellt sind. Wie den beiden Figuren zu entnehmen ist, sind insgesamt sieben kapazitive Berührungsschalter angeordnet.

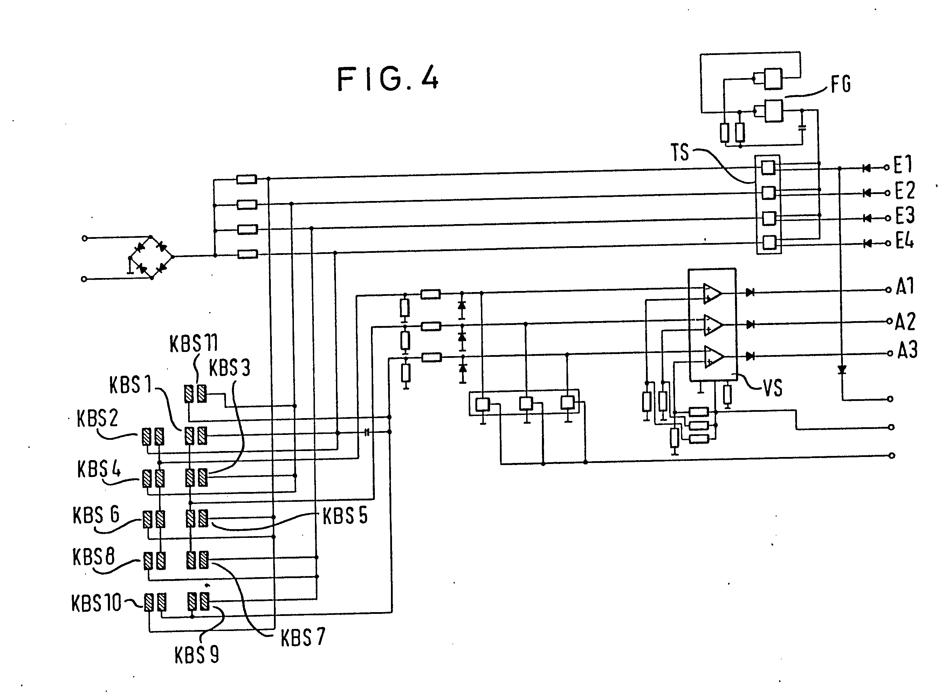

Die das Umfeld dieser kapazitiven Berührungsschalter KBS 1 bis 7 bildende Schaltungsanordnung zeigt die Fig. 4. Neben der Stromversorgung und weiteren nicht näher zu erläuternden Ein- und Ausgängen weist die Schaltungsanordnung vier Eingangsleitungen E1, E2, E3, E4 und drei Ausgangsleitungen A1, A2, A3 auf, die an eine Mikroprozessorschaltung angeschaltet sind. Ein Eingabesignal wird alternierend zyklisch an die Eingänge E1 bis E4 ange legt, so daß über die Und-Verknüpfungsglieder der Vorschaltung TS entsprechend zyklisch je in einem Frequenzgenerator FG erzeug te Hochfrequenzgruppen von ersten Kondensatorflächen der kapazitiven Berührungsschalter KBS 1 bis 11 zugeführt werden. Jeweils zwei oder drei kapazitive Berührungsschalter KBS 1 bis 11 sind z einer Gruppe zusammengefaßt und es sind entsprechend der Eingang leitungen E1 bis E4 vier Gruppen gebildet. Kapazitive Berührung schalter KBS 1 bis 11 jeweils einer gemeinsamen Gruppe sind unte schiedlichen Ausgangsleitungen A1, A2, A3 zugeordnet, so daß dur gemeinsame Auswertung der Belegung der Eingänge E1 bis E4 und de Ausgänge A1 bis A3 eine eindeutige Zuordnung der elf kapazitiver Berührungsschalter KBS 1 bis 11 zur Auswertung der einzugebende Steuerfunktionen gegeben ist. Schaltverstärker SV bereiten die Ausgangssignale zur Verarbeitung in einer nachgeschalteten Scha tungsanordnung auf.

Wie der Fig. 3 zu entnehmen ist, ist die bedienungsseitige Kondensatorfläche des kapazitiven Berührungsschalters KBS 9 ringförmig über Stege in den Bereich der übrigen kapazitiven Berührungsschalter herangeführt. Schaltungstechnisch wird dieser kapazitive Berührungsschalter 9 entsprechend als Sicherheitsschalter zusätzlich ausgewertet. Die entsprechende Maßnahme gemäß Fig. 2 kann angewendet werden, ist aber nicht zwangsweise erforderlich.

0054306

TZP 80/653 E

Patentansprüche

1. Kapazitiver Berührungsschalter für elektrische Hausgeräte, vorzugsweise für Kochmulden aus Glas oder Glaskeramik, mit auf beiden Seiten eines aus dielektrischem, plattenartigem Material bestehenden Schalttableau aufgebrachten Kondensatorflächen, d a d u r c h   g e k e n n z e i c h n e t , daß auf der der Bedienseite für die Eingabe des Schaltbefehls gegenüberliegenden Seite des dielektrischen, plattenartigen Materials (1) je Eingabestelle zwei Kondensatorflächen (4, 5) aufgebracht sind, von denen eine erste Kondensatorfläche (5) an einen Frequenzgenerator (FG) und eine zweite Kondensatorfläche (4) an einer Auswerteschaltung angeschlossen sind, und daß auf der Bedienseite eine zumindest den Bereich dieser beiden Kondensatorflächen (4, 5) überdeckende weitere Kondensatorfläche (2) angeordnet ist.

2. Kapazitiver Berührungsschalter nach Anspruch 1, dadurch gekennzeichnet, daß die auf der Bedienseite des dielektrischen, plattenartigen Materials (1) angeordnete Kondensatorfläche (2) sich über den Bereich der auf der anderen Seite angeordneten Kondensatorflächen (4, 5) hinaus erstreckt.

3. Kapazitiver Berührungsschalter nach einem der Ansprüche 1 oder 2, dadurch gekennzeichnet, daß die weitere auf der Bedienseite des dielektrischen, plattenartigen Materials (1) angeordnete Kondensatorfläche (2) einer zum Eingabeschutz ausgebildeten Eingabestelle (KBS9) in die Randbereiche der übrigen Eingabestellenflächen (KBS1 bis KBS8, KBS10, KBS11) herangeführt ist.

- 1 -

4. Kapazitiver Berührungsschalter nach einem der Ansprüche
1 bis 3, dadurch gekennzeichnet, daß die erste Kondensatorfläche (5) an einen Frequenzgenerator (FG) angeschlossen ist, dessen Schwingfrequenz zwischen 20 und
200 kHz liegt.

5. Kapazitiver Berührungsschalter nach einem der Ansprüche
1 bis 4, dadurch gekennzeichnet, daß der Frequenzgenerator (FG) gebildet ist durch einen aus astabilen Kippstufen aufgebauten Multivibrator.

6. Anordnung     einer Mehrzahl von kapazitiven Berührungsschaltern, die über eine Mikroprozessorsteuerung auswertbar sind, nach einem der Ansprüche 1 bis 5, dadurch
gekennzeichnet, daß über eine aus Und-Verknüpfungsgliedern
aufgebaute Torschaltung (TS) in Abhängigkeit der von der
Mikroprozessorsteuerung gelieferten Auswertesignale der
Frequenzgenerator (FG) zyklisch den ersten Kondensatorflächen der Eingabestellen (KBS1 bis 11) zuschaltbar
ist.

7. Anordnung einer Mehrzahl von kapazitiven Berührungsschaltern nach einem der Ansprüche 1 bis 6, dadurch gekennzeichnet, daß eine Mehrzahl von zweiten Kondensatorflächen
(4) der Eingabestellen (KBS1 bis 11) gemeinsam einem der
Auswerteeingänge (A1, A2, A3) der Auswerteschaltung zugeführt sind.

8. Kapazitiver Berührungsschalter nach einem der Ansprüche
1 bis 7, dadurch gekennzeichnet, daß zwischen der zweiten
Kondensatorfläche (4) und der Auswerteschaltung ein Schaltverstärker (SV) geschaltet ist.

9. Kapazitiver Berührungsschalter nach einem der Ansprüche
1 bis 8, dadurch gekennzeichnet, daß die Kondensatorfläche (2) auf der Bedienseite durch eine auf das Schalttableau (1) unlösbar aufgebrachte dielektrische Schicht
(6) überzogen ist.

10. Kapazitiver Berührungsschalter nach Anspruch 9, dadurch
gekennzeichnet, daß die Schicht (6) durchsichtig und
im Erscheinungsbild an die Oberfläche des Schalttableaus
(1) angepaßt ist.

11. Kapazitiver Berührungsschalter nach einem der Ansprüche
9 oder 10, dadurch gekennzeichnet, daß die Kondensatorfläche (2) durch eine kratzfeste Dekorschicht vorzugsweise aus Glas und/oder Keramik überzogen ist.

12. Kapazitiver Berührungsschalter nach einem der Ansprüche
1 bis 11, dadurch gekennzeichnet, daß die Kondensatorflächen (4, 5) zumindest auf der der Bedienungsseite entgegengesetzten Rückseite (3) des Schalttableaus (1) aus
einem lötbaren Material, vorzugsweise aus einer Silberleitpaste, bestehen, an die elektrische Leitungen anlötbar sind.

FIG.1

FIG.2

FIG.3

KBS 11

KBS 1          KBS 2

KBS 3          KBS 4

KBS 5          KBS 6

KBS 7          KBS 8

KBS 10

KBS 9

KBS 11

KBS 1          KBS 2

KBS 3          KBS 4

KBS 5          KBS 6

KBS 7          KBS 8

KBS 10

KBS 9

# FIG. 4

FG

TS

E1
E2
E3
E4

A1
A2
A3

VS

KBS 11
KBS 3
KBS 1
KBS 2
KBS 4
KBS 6
KBS 5
KBS 8
KBS 10
KBS 9
KBS 7

0054306

Nummer der Anmeldung

EP 81 11 0493

Europäisches
Patentamt

**EUROPÄISCHER RECHERCHENBERICHT**

| EINSCHLÄGIGE DOKUMENTE | | | KLASSIFIKATION DER ANMELDUNG (Int Cl.³) |
|---|---|---|---|
| Kategorie | Kennzeichnung des Dokuments mit Angabe. soweit erforderlich. der maßgeblichen Teile | betrifft Anspruch | |
| X | FR - A - 2 374 811 (GENERAL ELECTRIC CO.) <br><br> * Seite 4, Zeile 5 bis Seite 12, Zeile 24; Figuren 1-4,6 und 7 * <br><br> & DE - A - 2 755 678 <br><br> -- | 1,2,4, 5,8, 10,12 | H 03 K 17/96 <br> H 05 B 3/74 |
| A | DE - A - 2 831 783 (THE SINGER CO.) <br><br> * Seite 12, letzter Absatz bis Seite 14, Zeile 27; Seite 28, Zeile 18 bis Seite 29, Zeile 26; Figuren 3 und 7 * <br><br> -- | 6,7 | |
| A | DE - A - 2 822 847 (PENTEL KK) <br><br> * Seite 10 bis Seite 12, Zeile 2; Figuren 1 und 2 * <br><br> -- | 1,3, 9,10 | **RECHERCHIERTE SACHGEBIETE (Int. Cl.³)** <br><br> H 03 K <br> H 05 B |
| A | IEEE TRANSACTIONS ON BROADCAST AND TELEVISION RECEIVERS, Band BTR-20, Nr.4, November 1974 NEW YORK (US) WHELPLEY: "Solid State Audio Control", Seiten 299-310 <br><br> * Seite 301; Figur 9 * <br><br> -- | 1,5 | |

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

| | Der vorliegende Recherchenbericht wurde für alle Patentansprüche erstellt. | |
|---|---|---|
| Recherchenort <br> DEN HAAG | Abschlußdatum der Recherche <br> 18-03-1982 | Prüfer <br> CANTARELLI |

EPA form 1503.1  06.78